# EUROPEAN PATENT SPECIFICATION

(11) **EP 0 384 482 B1**
(45) Date of publication and mention of the grant of the patent: **30.08.1995**
(21) Application number: 90103571.7
(22) Date of filing: 23.02.1990
(51) Int. Cl.: H01L 23/04, H01L 23/24

(54) **Composite semiconductor device**
Zusammengesetzte Halbleitervorrichtung
Dispositif semi-conducteur composé

(30) Priority: 23.02.1989 JP 44322/89
(43) Date of publication of application: 29.08.1990
(73) Proprietor: MITSUBISHI DENKI KABUSHIKI KAISHA, Tokyo (JP)
(72) Inventor: Yamamoto, Takeshi, c/o Mitsubishi Denki K.K., Itami-Shi, Hyogo (JP); Nakatsuka Masanori, c/o Mitsubishi Denki K.K., Itami-Shi, Hyogo (JP)
(74) Representative: Sajda, Wolf E., Dipl.-Phys.

(56) References cited:
- EP-A- 0 251 260
- JP-A-60 157 241

## Description

The invention relates to a composite semiconductor device, comprising:
- a rectangular base plate;
- a plurality of semiconductor elements mounted on the base plate and connected to each other;
- a rectangular case of corresponding shape to the base plate and fixed thereon for packaging the semiconductor elements and having four main side walls;
- two opposing main side walls at opposite sides of the case having an inner sidewall and an outer sidewall with a gap therebetween, thereby forming a cavity, each inner sidewall being provided with an opening which connects each cavity with the inside of the case, wherein the opening is provided at a boundary between the base plate and the case, and the two opposing main side walls are provided with recesses along a central axis of the device for fixation of the device at the opposite sides thereof;
- a resin injected into the case for sealing the semiconductor elements, the resin, comprising soft resin up to a predetermined height of the case and thermosetting resin on the soft resin;
- the opening being provided under the predetermined height of the case.

Such a composite semiconductor device, for example a power module, comprises a plurality of semiconductor elements connected with each other through wires and packaged in the case filled with the resin.

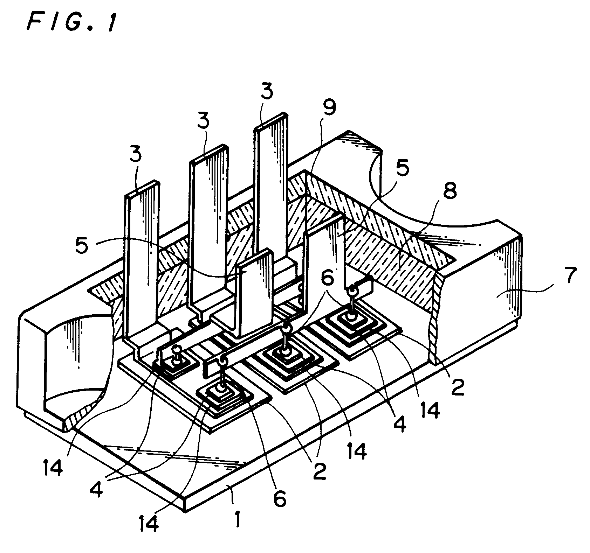

Fig. 1 is a perspective diagram showing a conventional diode module of a three-phase bridge structure. Referring to Fig. 1, three insulation substrates 2 and alternating current terminals 3 are fixed on a metal base plate 1 in this sequence and two (six in total) die pads 14 and diode chips 4 are fixed on each alternating current terminal 3 in this sequence, by means of solder or the like. These six diode chips 4 are connected with direct current terminals 5 through electrode leads 6 by means of solder so that a three-phase bridge structure is implemented. A resin case 7 is fixed onto the metal base plate 1 by means of adhesive. After a soft resin 8 such as silicone gel and silicone rubber nas been injected into the case 7 to be cured, a thermosetting resin 9 such as epoxy resin is injected and a cap (not shown) is put on the case 7 and thereafter the thermosetting resin 9 is hardened.

When current is supplied to the diode chips 4, the temperature of the diode chips 4 is increased. This results in the increase of temperature of the electrodes 3 and 5 and the silicone gel 8 surrounding of the respective diode chips 4, so that the silicone gel 8 expands. In general, the expansion coefficient of the silicone gel 8 is about ten times greater than that of the epoxy resin 9. Therefore, an internal pressure due to the expansion of the silicone gel 8 becomes extremely large and it functions as a force pushing the epoxy resin 9 upward. Thus, solders in the vicinity of the diode chips 4 are subjected to tensile stress. Thus, a fatigue of the solders is disadvantageously caused in a relatively short period due to alternate expansion and contraction of the silicone gel 8 caused by the ON/OFF switching of the diode chips 4.

From EP-A-02 51 260 or JP-A-60-157-241 a composite semiconductor device is known of the type as specified above and considered in the preamble of claim 1. In this conventional composite semiconductor device two cavities are provided one at each side of the casing. For obtaining a space within the cavities large enough for compensating thermal contraction and expansion of the soft resin, the overall size of the casing need to be increased.

It is an object of the present invention to provide a composite semiconductor device of the type specified above and having cavities for compensating thermal expansion and contraction of the soft resin without increasing the overall size of the device.

The solution according to the invention is characterized in that in the composite semiconductor device of the type specified above, the recesses divide the two opposing main side walls such that four cavities are provided at the corners of the device. By dividing the two cavities according to the prior art devices into four cavities and arranging the cavities at the corners of the device, the space for mounting the electronic parts of the device is not decreased when compared with a device not having any cavity.

According to a further development of the device according to the invention, the soft resin includes silicone gel.

According to a further development of the device according to the invention, the soft resin included silicone rubber.

According to a further development of the device according to the invention, the thermal setting resin includes a epoxy resin.

In a specific embodiment according to the device of the invention, the two opposing main side walls are each provided with another opening for connecting the cavity with an outside of the case.

According to a further development of this specific device, the other opening is provided at an upper surface of the two main opposing side walls.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a perspective diagram showing a conventional diode module;
Fig. 2 is a perspective diagram showing a diode module as an embodiment of a composite semiconductor device according to the present invention; and
Fig. 3 is a cross-sectional view taken along the line III-III of Fig. 2.

### DETAILED DESCRIPTION OF THE PREFERRED EMBODIMENTS

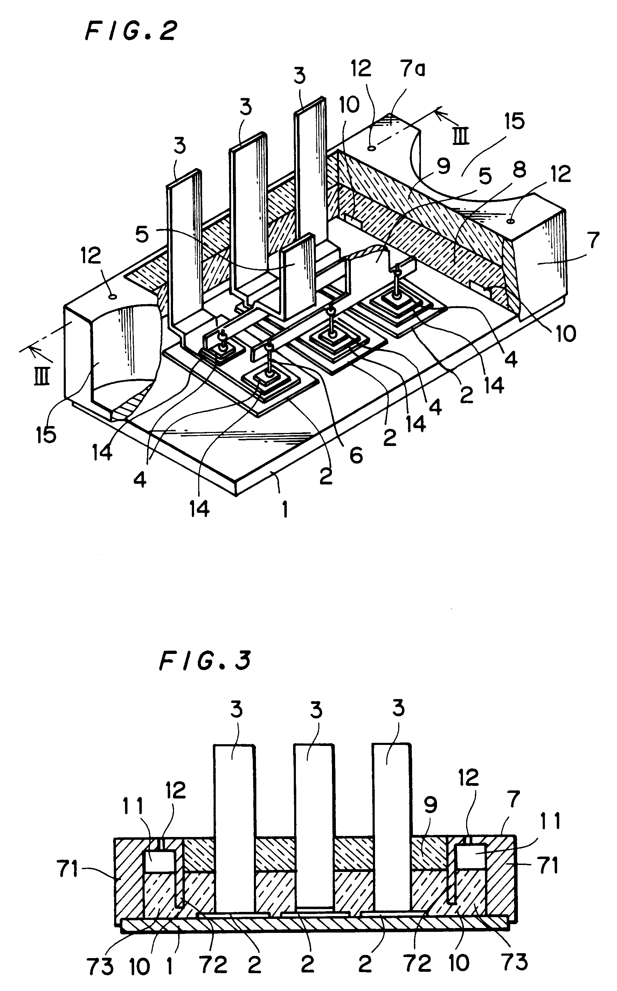

Fig. 2 is a perspective diagram showing a diode module of a three-phase structure which is an embodiment of a composite semiconductor device according to the present invention, and Fig. 3 is a cross-sectional view taken along the line III-III of Fig. 2.

Referring to Fig. 2 and Fig. 3, three insulation substrates 2 and alternating current terminals 3 are fixed on a metal base plate 1 in this sequence and two (six in total) die pads 14 and diode chips 4 are fixed on each alternating current terminal 3 in this sequence, by means of solder or the like. These six diode chips 4 are connected with direct current terminals 5 through electrode leads 6 by means of solder so that a three-phase bridge structure is implemented. A resin case 7 is fixed onto the metal base plate 1 by means of adhesive.

The case 7 comprises rectangular side wall which has outer side walls 71 and inner side walls 72 at the four corners of the rectangular configuration. Cavities 73 are defined between the inner and outer side walls 71 and 72, and thus the side wall of the case 7 is provided with four cavities 73 at the four corners. The side wall of the case 7 is also provided with recesses 15 for fixation of the diode module at opposite sides of the rectangular side wall. Portions adjacent to the recesses 15 of the side wall are advantageously utilized for the cavities 73.

The cavities 73 are connected with the inside of the case 7 through openings 10 provided at boundaries between the inner side walls 72 and the base plate 1. The cavities 73 are also connected with the outside of the case 7 through openings 12 provided at the upper surface of the case 7.

A soft resin 8 such as silicone gel and silicone rubber is injected into the case 7 up to a predetermined height to be cured. The soft resin 8 enters the cavities 73 through the openings 10 since the openings 10 are provided under the predetermined height. Then, a thermosetting resin 9 such as an epoxy resin is injected onto the soft resin 8 and a cap (not shown) is put on the case 7 and thereafter the thermosetting resin 9 is hardened. Since the thermosetting resin 9 does not enter into the cavities 73, empty spaces 11 remain in the cavities 73.

When current is supplied to the diode chips 4, the temperature of the diode chips 4 is increased. This causes an expansion of the silicone gel 8. However, the increase of internal pressure due to the expansion can effectively be absorbed by virtue of the spaces 11, and hence the internal pressure hardly functions as a force pushing the epoxy resin 9 upward. As a result, any fatigue of the solders is hardly caused so that the lifetime of the diode module can be lengthened with respect to its ON/OFF switching.

The openings 12 are provided in order to enhance the effect of absorbing the internal pressure. However, the openings 12 may be deleted in such a case that the internal pressure is not so large.

The present invention is also applicable not only to another power module such as a thyristor module but also to any other composite semiconductor device.

Although the present invention has been described and illustrated in detail, it is clearly understood that the same is by way of illustration and example only and is not to be taken by way of limitation. The scope of the present invention should be limited only by the terms of the appended claims.

## Claims

1. A composite semiconductor device, comprising:
- a rectangular base plate (1);
- a plurality of semiconductor elements (4) mounted on the base plate (1) and connected to each other;
- a rectangular case (7) of corresponding shape to the base plate (1) and fixed thereon for packaging the semiconductor elements (4) and having four main side walls (71, 72);
- two opposing main side walls at opposite sides of the case (7) having an inner sidewall (72) and an outer sidewall (71) with a gap therebetween, thereby forming a cavity (73), each inner sidewall being provided with an opening (10) which connects each cavity (73) with the inside of the case (7), wherein the opening (10) is provided at a boundary between the base plate (1) and the case (7), and the two opposing main side walls (71, 72) are provided with recesses (15) along a central axis of the device for fixation of the device at the opposite sides thereof,
- a resin (8, 9) injected into the case (7) for sealing the semiconductor elements (4), the resin (8, 9) comprising soft resin (8) up to a predetermined height of the case (7) and thermosetting resin (9) on the soft resin (8);
- the opening (10) being provided under the predetermined height of the case (7),
- characterized in that the recesses (15) divide the two opposing main side walls such that four cavities (73) are provided at the corners of the device.

2. The device in accordance with claim 1,
wherein the soft resin (8) includes silicone gel.

3. The device in accordance with any of claims 1 or 2,
wherein the soft resin (8) includes silicone rubber.

4. The device in accordance with any of claims 1 to 3,
wherein the thermosetting resin (9) includes epoxy resin.

5. The device in accordance with any of claims 1 to 4,
wherein the two opposing main side walls (71, 72) are each provided with another opening (12) for connecting the cavity (73) with an outside of the case (7).

6. The device in accordance with claim 5,
wherein the other opening (12) is provided at an upper surface of the two main opposing side walls (71, 72).

## Patentansprüche

1. Zusammengesetzte Halbleitervorichtung, die folgendes aufweist:
- eine rechteckige Grundplatte (1);
- eine Vielzahl von Halbleiterelementen (4), die auf der Grundplatte (1) montiert und miteinander verbunden sind;
- ein rechteckiges Gehäuse (7) mit einer der Grundplatte (1) entsprechenden Form, das an dieser befestigt ist, um die Halbleiterelemte (4) unterzubringen, und vier Hauptseitenwände (71, 72) aufweist;
- zwei gegenüberliegende Hauptseitenwände an gegenüberliegenden Seiten des Gehäuses (7) mit einer inneren Seitenwand (72) und einer äußeren Seitenwand (71) mit einem Spalt dazwischen, um dadurch einen Hohlraum (73) bilden, wobei jede innere Seitenwand mit einer Öffnung (10) versehen ist, die jeden Hohlraum (73) mit der Innenseite des Gehäuses (7) verbindet, wobei die Öffnung (10) an der Grenze zwischen der Grundplatte (1) und dem Gehäuse (7) ausgebildet ist und wobei die zwei gegenüberliegenden Hauptseitenwände (71, 72) mit Vertiefungen (15) entlang der Mittelachse der Vorrichtung zum Befestigen der Vorrichtung an ihren gegenüberliegenden Seiten ausgebildet sind;
- ein Harz (8, 9), das in das Gehäuse (7) zum Abdichten des Halbleiterelements (4) eingespritzt ist, wobei das Harz (8, 9) weiches Harz (8) bis zu einer vorbestimmten Höhe des Gehäuses (7) und wärmehärtbares Harz (9) auf dem weichen Harz aufweist;
- wobei die Öffnung (10) unterhalb der vorbestimmten Höhe des Gehäuses (7) ausgebildet ist;
dadurch gekennzeichet,
daß die Vertiefungen (15) die zwei gegenüberliegenden Hauptseitenwände derart teilt, daß vier Hohlräume (73) in den Ecken der Vorrichtung ausgebildet sind.

2. Vorichtung nach Anspruch 1,
wobei das weiche Harz (8) Silikongel aufweist.

3. Vorrichtung nach einem der Ansprüche 1 und 2,
wobei das weiche Harz (8) Silikongummi aufweist.

4. Vorrichtung nach einem der Ansprüche 1 bis 3,
wobei das wärmehärtbare Harz (9) Epoxidharz aufweist.

5. Vorrichtung nach einem der Ansprüche 1 bis 4,
wobei die zwei gegenüberliegenden Hauptseitenwände (71, 72) jeweils mit einer weiteren Öffnung (12) zum Verbinden des Hohlraums (73) mit einer Außenseite des Gehäuses (7) ausgebildet sind.

6. Vorrichtung nach Anspruch 5,
wobei die weitere Öffnung (12) an der Oberfläche der zwei gegenüberliegenden Hauptseitenwände (71, 72) ausgebildet ist.

## Revendications

1. Dispositif semi-conducteur composé, comprenant :
- une plaque de base rectangulaire (1) ;
- une pluralité d'éléments semi-conducteurs (4) montés sur la plaque de base (1) et connectés les uns aux autres ;
- un casier rectangulaire (7) d'une forme qui correspond à la plaque de base (1) et fixé sur celle-ci pour enfermer les éléments semi-conducteurs (4) et présentant quatre parois latérales principales (71, 72) ;
- deux parois latérales principales opposées sur les côtés opposés du casier (7), comprenant une paroi latérale intérieure (72) et une paroi latérale extérieure (71) avec un intervalle entre elles, formant ainsi une cavité (73), chaque paroi latérale étant pourvue d'une ouverture (10) qui connecte chaque cavité (73) avec l'intérieur du casier (7) ; où l'ouverture (10) est prévue à une frontière entre la plaque de base (1) et le casier (7), et les deux parois latérales principales opposées (71, 72) sont pourvues d'évidements (15) le long d'un axe central du composant pour la fixation du composant sur les côtés opposés de celui-ci ;
- une résine (8, 9) injectée à l'intérieur du casier (7) pour sceller les éléments semi-conducteurs (4), la résine (8, 9) comprenant une résine tendre (8) jusqu'à une hauteur prédéterminée du casier (7) et une résine thermodurcissable (9) sur la résine tendre (8) ;
- l'ouverture (10) étant prévue au-dessous de la hauteur prédéterminée du casier (7) ;
- caractérisé en ce que les évidements (15) divisent les deux parois latérales principales opposées de telle manière que quatre cavités (73) sont réalisées aux coins du dispositif.

2. Dispositif selon la revendication 1,
dans lequel la résine tendre (8) comprend un gel au silicone.

3. Dispositif selon l'une ou l'autre des revendications 1 et 2,
dans lequel la résine tendre (8) comprend un caoutchouc au silicone.

4. Dispositif selon l'une quelconque des revendications 1 à 3,
dans lequel la résine thermodurcissable (9) comprend une résine époxyde.

5. Dispositif selon l'une quelconque des revendications 1 à 4,
dans lequel les deux parois latérales principales opposées (71, 72) sont pourvues chacune d'une autre ouverture (12) pour connecter la cavité (73) avec l'extérieur du casier (7).

6. Dispositif selon la revendication 5,
dans lequel l'autre ouverture (12) est prévue au niveau d'une surface supérieure des deux parois latérales principales opposées (71, 72).
